# FASCICULE DE BREVET EUROPEEN

(11) **EP 1 995 740 B1**
(45) Date de publication et mention de la délivrance du brevet: **17.02.2010**
(21) Numéro de dépôt: 08156510.3
(22) Date de dépôt: 20.05.2008
(51) Int. Cl.: H01F 17/00

(54) **Structure inductive plane**
Ebene Induktionsstruktur
Flat inductive structure

(30) Priorité: 23.05.2007 FR 0755212
(43) Date de publication de la demande: 26.11.2008
(73) Titulaire: ST MICROELECTRONICS S.A., 92120 Montrouge (FR)
(72) Inventeur: Ezzeddine, Hilal, 37100, TOURS (FR)
(74) Mandataire: de Beaumont, Michel

(56) Documents cités:
- EP-A- 0 649 152
- BE-A- 431 839
- FR-A- 2 772 973
- JP-A- 5 275 247
- JP-A- 2002 280 230
- US-A- 6 114 937

## Description

### Domaine de l'invention

La présente invention concerne de façon générale la réalisation d'éléments inductifs en utilisant des technologies de fabrication des circuits intégrés et circuits imprimés. L'invention concerne plus particulièrement la réalisation d'enroulements inductifs plans.

### Exposé de l'art antérieur

La réalisation d'un enroulement inductif plan s'effectue par formation d'une piste conductrice en spirale dans un niveau conducteur d'un circuit intégré ou d'un circuit imprimé. Le plus souvent, la structure en spirale est, dans le plan, entourée par une surface destinée à être connectée à la masse (plan de masse). Selon les applications, plusieurs enroulements spiralés peuvent être interdigités dans un même plan et plusieurs enroulements ou paires d'enroulements peuvent être superposés dans des niveaux conducteurs différents pour réaliser des structures couplées.

Un problème, rendu de plus en plus critique par les besoins de miniaturisation, est un échauffement important au centre de la structure spiralée. Cet échauffement peut conduire à une détérioration de la structure ou nécessiter une augmentation de largeur de la piste conductrice, contraire à la miniaturisation souhaitée (voir, par exemple, US 6 114 937, EP 0 649 152, JP 05 275247 (PAJ), JP 2002 280230 (PAJ), FR 2 772 973 ou BE 431 839).

### Résumé de l'invention

Un objet de la présente invention est de pallier tout ou partie des inconvénients des structures spiralées usuelles.

Un autre objet est la réalisation d'une structure spiralée dont le comportement thermique est amélioré par rapport à une structure usuelle ayant des pistes de mêmes largeurs.

Un autre objet est une structure spiralée plus particulièrement destinée à être encadrée par un plan conducteur.

Pour atteindre tout ou partie de ces objets ainsi que d'autres, il est prévu une structure spiralée comportant au moins un enroulement plan dans au moins un premier niveau conducteur pour réaliser au moins un élément inductif, caractérisé en ce que :
ledit enroulement est entouré d'un plan conducteur ; et
au moins une piste conductrice est formée dans un deuxième niveau conducteur et a deux extrémités reliées par des vias conducteurs au plan du premier niveau, à des positions diamétralement opposées par rapport au centre de l'enroulement.

Selon un mode de réalisation, ladite piste conductrice est continue d'une extrémité à l'autre.

Selon un mode de réalisation, ladite piste conductrice est interrompue au centre de l'enroulement.

Selon un mode de réalisation, la largeur de la piste conductrice est, au centre de l'enroulement, inférieure ou égale au tiers du diamètre interne de l'enroulement.

Selon un mode de réalisation, ledit plan conducteur est destiné à être raccordé à un potentiel de référence.

Selon un mode de réalisation, plusieurs pistes conductrices sont réparties dans le deuxième niveau conducteur en ayant leurs extrémités respectives reliées au plan conducteur du premier niveau.

Selon un mode de réalisation, au moins un deuxième enroulement est réalisé dans un troisième niveau conducteur superposé aux deux premiers.

Selon un mode de réalisation, deux enroulements plans interdigités sont formés dans le premier niveau.

Selon un mode de réalisation, la largeur de la piste conductrice est plus importante au centre de la structure qu'à ses extrémités destinées à être raccordées au plan conducteur du premier niveau.

Il est également prévu un élément inductif comportant une telle structure.

Il est également prévu un combineur/diviseur en lignes distribuées comportant :
une première ligne formée d'un premier enroulement plan dans un premier niveau conducteur et d'un deuxième enroulement plan dans un troisième niveau conducteur ; et
une deuxième ligne formée d'un troisième enroulement plan interdigité avec le premier enroulement dans le premier niveau, et d'un quatrième enroulement plan interdigité avec le deuxième enroulement dans le troisième niveau, une piste conductrice conforme à la structure ci-dessus étant formée dans un deuxième niveau conducteur superposé aux deux autres.

Selon un mode de réalisation, les enroulements ont une largeur croissante de l'intérieur vers l'extérieur.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est une vue de dessus d'un niveau conducteur d'un mode de réalisation d'une structure d'inductance spiralée ;
la figure 2 est une vue de dessus d'un autre niveau conducteur de la structure de la figure 1 ;
la figure 3 est une vue en coupe de la structure des figures 1 et 2 selon la ligne I-I de la figure 1 ;
la figure 4 représente le schéma électrique équivalent d'un mode de réalisation d'un combineur/diviseur ;
les figures 5A et 5B sont des vues de dessus de niveaux conducteurs participant à une réalisation intégrée de lignes couplées du combineur/diviseur de la figure 4 ;
la figure 6 est une vue de dessus d'un mode de réalisation du combineur/diviseur de la figure 4 ;
la figure 7 est une vue en coupe selon la ligne II-II de la figure 6 ;
la figure 8 est un schéma-blocs d'un exemple de circuit électronique utilisant des structures inductives réalisées par des enroulements plans ;
la figure 9 est un schéma-blocs d'un exemple de transformateur à changement de mode utilisant des structures inductives réalisées par des enroulements plans ;
la figure 10 représente un autre mode de réalisation d'une structure spiralée ;
la figure 11 représente encore un autre mode de réalisation d'une structure spiralée ;
la figure 12 illustre une variante d'une piste de transfert thermique ;
la figure 13 illustre une autre variante de piste de transfert thermique ; et
la figure 14 illustre encore une autre variante d'une piste de transfert thermique.

De mêmes éléments ont été désignés par de mêmes références aux différentes figures et, de plus, comme cela est habituel dans la représentation des circuits intégrés, les diverses figures ne sont pas tracées à l'échelle.

### Description détaillée

Par souci de clarté, seuls les étapes et éléments utiles à la compréhension de l'invention ont été représentés et seront décrits. En particulier, les applications d'une structure spiralée n'ont pas toutes été détaillées, une telle structure pouvant être utilisée en remplacement d'une structure usuelle dans toute application. De même, les procédés de réalisation de couches minces en utilisant des technologies de fabrication de circuits intégrés n'ont pas été détaillés, des techniques usuelles pouvant être mises en oeuvre.

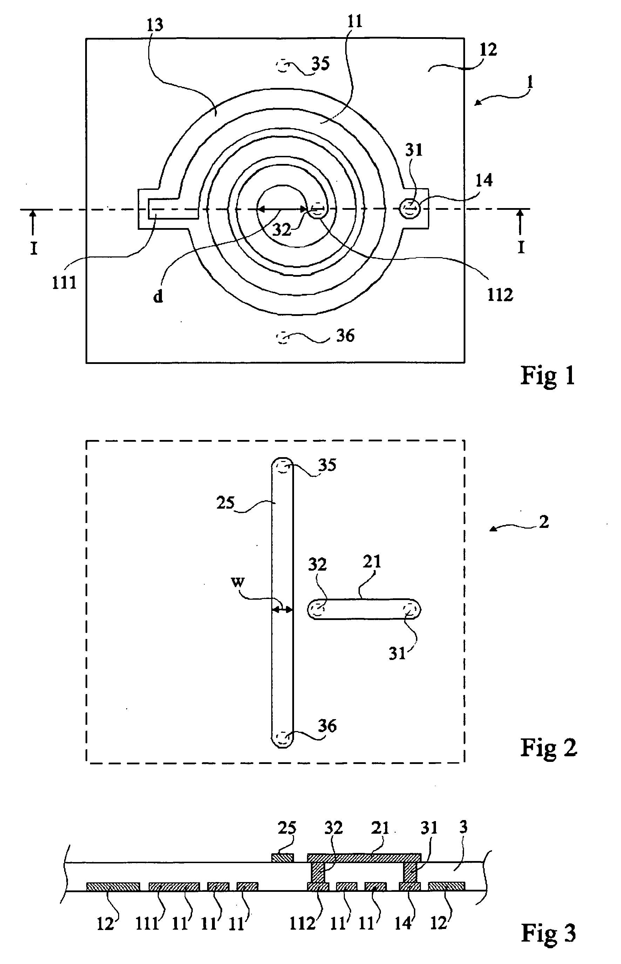

Les figures 1, 2 et 3 représentent, respectivement vue de dessus (figures 1 et 2) et en coupe (figure 3), une inductance réalisée sous la forme d'une structure spiralée au moyen de deux niveaux conducteurs 1 (figure 1) et 2 (figure 2), séparés l'un de l'autre par une couche isolante 3 (figure 3).

L'élément inductif est formé d'un enroulement plan 11 réalisé dans un niveau conducteur 1 en étant entouré d'un plan conducteur 12. En d'autres termes, l'enroulement 11 est réalisé dans une ouverture 13 du plan conducteur 12. Le plan 12 est, par exemple, destiné à être connecté à un potentiel de référence, par exemple, la masse. Dans l'exemple représenté, une première extrémité externe 111 de l'enroulement 11 est destinée à être connectée à un premier élément d'un circuit électronique (non représenté) tandis qu'une deuxième extrémité interne 112 est destinée à être reliée à un deuxième élément du circuit électronique. Si besoin, pour ressortir l'extrémité interne 112 de l'enroulement inductif, on utilise une piste conductrice 21 (figure 2), par exemple dans le niveau conducteur 2. Cette piste est par exemple rectiligne et a ses deux extrémités reliées par des vias 31 et 32 respectivement à un plot conducteur 14 réalisé dans l'ouverture 13 ou dans une autre ouverture du plan 12 du niveau 1, et à l'extrémité 112 de l'enroulement 11 dans le niveau 1. Les connexions respectives de l'extrémité 111 et du plot 14 au reste du circuit électronique s'effectuent, par exemple, dans un autre niveau conducteur (non représenté) au moyen de vias, ou par des raccordements filaires. Dans l'exemple représenté, on suppose que ces connexions s'effectuent par le dessous de la structure de la figure 3, le niveau 1 étant supposé le niveau inférieur. L'inverse est bien entendu possible avec le niveau 2 enterré et le niveau 1 au-dessus. De même, la piste 21 peut être dans un autre niveau que le niveau 2.

Le niveau conducteur 2 comporte une piste ou pont conducteur 25 traversant la structure spiralée pour connecter, par ses deux extrémités, le plan 12. Dans l'exemple représenté, le pont 25 est perpendiculaire à la piste 21. Ses deux extrémités sont reliées par des vias 35 et 36 au plan de masse 12 du niveau conducteur 1.

La présence du pont conducteur 25 reliant le plan de masse 12 dans le deuxième niveau permet d'améliorer le comportement thermique de la structure spiralée en captant la chaleur de l'enroulement et plus particulièrement celle dégagée en son centre pour l'évacuer par le plan de masse auquel le pont thermique 25 est relié. On tire profit de la répartition de la densité de courant dans un enroulement conducteur qui est plus grande au centre de l'enroulement qu'en périphérie.

Afin de ne pas dégrader les performances électriques (en particulier les facteurs de qualité) de l'élément inductif, la largeur W (figure 2) de la piste 25 de reprise thermique est inférieure ou égale au tiers du diamètre interne d (figure 1) de la structure spiralée.

De préférence, le pont 25 est le moins large possible. L'impact sur les performances électriques de la structure inductive est alors minimal alors que l'évacuation thermique est assurée.

Si plus de deux niveaux sont utilisés, la piste 25 est de préférence réalisée dans le niveau le plus proche de l'enroulement (au-dessus ou en dessous) pour favoriser le transfert thermique.

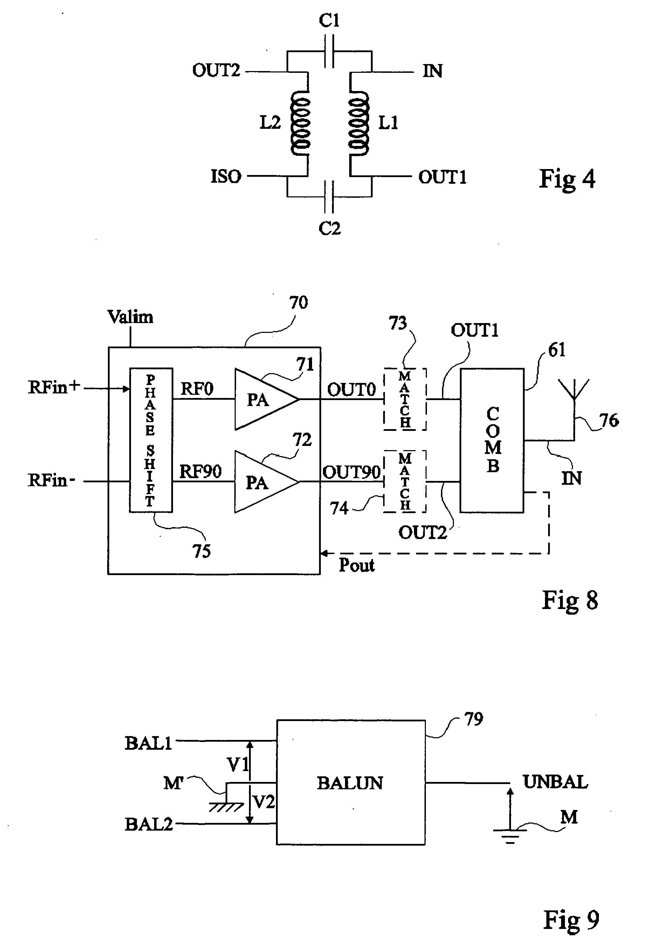

La figure 4 représente le schéma électrique équivalent d'un combineur/diviseur susceptible d'être réalisé au moyen d'une structure spiralée à pont thermique.

Un combineur/diviseur comporte un accès IN, désigné arbitrairement d'entrée, destiné à recevoir un signal dont la puissance est à répartir (ou à fournir un signal combiné) et deux accès OUT1 et OUT2, désignés arbitrairement de sortie, destinés à fournir des signaux de puissance répartis (ou à recevoir des signaux dont les puissances sont à combiner). Ce circuit a non seulement pour rôle de répartir équitablement la puissance d'entrée entre les accès de sortie en phase ou en quadrature de phase, mais également d'assurer l'isolation entre ces accès. Un tel dispositif est le plus souvent directionnel, c'est-à-dire qu'il peut servir selon son montage dans un circuit électronique, à combiner deux puissances en un seul signal ou à équirépartir une puissance en deux puissances égales. Un premier élément inductif L1 relie la borne IN dite d'accès combiné à l'une, par exemple OUT1, des bornes dites d'accès répartis. Un deuxième élément inductif L2 relie une deuxième borne d'accès réparti OUT2 à une borne ISO généralement laissée en l'air. Selon que la borne OUT2 est du côté de la borne IN ou du côté de la borne OUT1, les accès répartis sont en quadrature de phase ou en phase. Dans certains cas, la borne ISO n'est pas laissée en l'air mais est chargée par une impédance normalisée (typiquement 50 ohms). Le combineur devient alors directif, c'est-à-dire qu'un signal entrant par la borne IN (généralement raccordé à une antenne) est piégé par la borne ISO de façon à éviter que ce signal atteigne l'application (typiquement les amplificateurs d'une chaîne d'émission ou de réception radiofréquence). Pour obtenir un effet de combineur/diviseur, le coupleur réalisé doit être à 3 dB de façon à ce que la puissance de la borne IN soit répartie par moitié sur chacune des bornes OUT1 et OUT2.

Dans l'exemple de la figure 4, les extrémités définissant les accès IN et OUT2 sont reliées par un premier élément capacitif C1 tandis que les extrémités définissant les accès OUT1 et ISO sont reliées par un deuxième élément capacitif C2. Le rôle des éléments capacitifs C1 et C2 est d'accroître le couplage entre les lignes sans modifier leur impédance. Un autre effet des éléments capacitifs prévus des deux côtés est de rendre symétrique la structure.

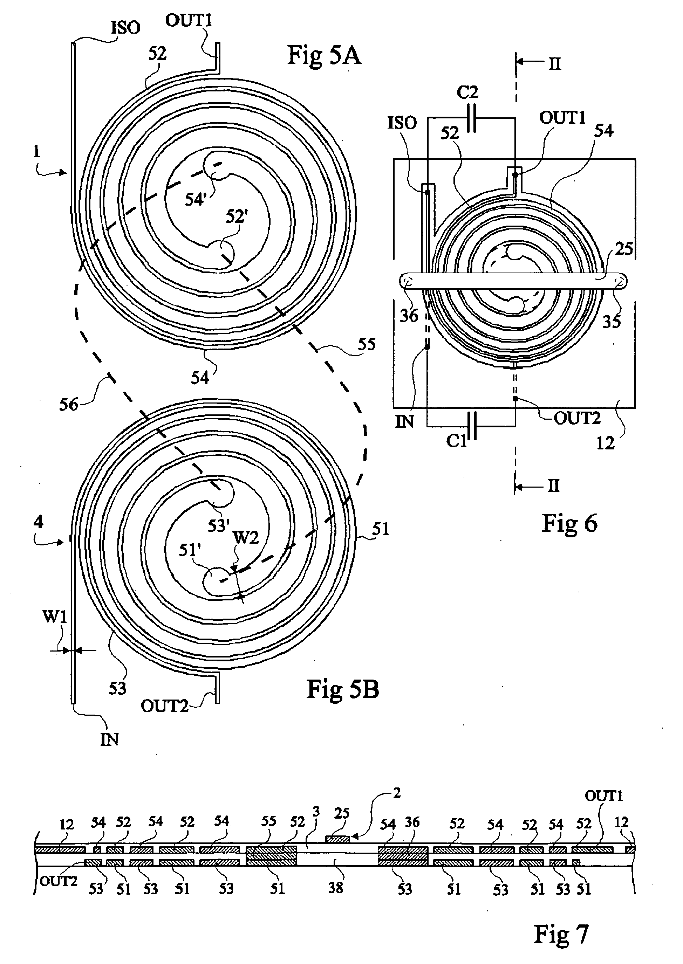

Les figures 5A, 5B, 6 et 7 illustrent une réalisation des éléments inductifs L1 et L2 sous la forme d'une structure spiralée d'enroulements conducteurs plans. Les figures 5A et 5B sont des vues schématiques de deux niveaux conducteurs 1 et 4 pour cette réalisation. La figure 6 et une vue de dessus illustrant les niveaux des figures 5A et 5B empilés ainsi qu'un autre niveau conducteur dans lequel est réalisé un pont de reprise thermique. La figure 7 est une vue en coupe selon la ligne II-II de la figure 6.

Dans cet exemple, les lignes couplées du combineur/diviseur sont réalisées sous la forme d'enroulements plans dans les deux niveaux 1 et 4, empilés l'un sur l'autre, chaque niveau comportant deux enroulements interdigités. Les pistes sont de plus de largeur croissante depuis l'extérieur de chaque enroulement jusqu'au centre. Cette largeur croissante améliore encore le comportement thermique de la structure. Ainsi, en prévoyant une largeur croissante vers le centre de l'enroulement, on peut dimensionner un combineur/diviseur d'encombrement réduit pour un courant donné par rapport à une réalisation à largeur de piste constante. Cet effet d'amélioration du comportement thermique s'ajoute alors à l'effet d'une piste 25 (figure 6) réalisée dans le niveau conducteur 2.

Comme l'illustrent les figures 5A et 5B, l'élément inductif L1 est formé de deux enroulements plans 51 et 52 réalisés dans les niveaux 1 et 4 qui sont superposés et séparés par un isolant 38 (figure 7). L'élément inductif L2 est également formé de deux enroulements plans 53 et 54, respectivement dans les niveaux 1 et 4. L'enroulement 53 est interdigité (entrelacé) avec l'enroulement 51 tandis que l'enroulement 54 est interdigité avec l'enroulement 52. Les extrémités externes des enroulements 51, 52, 53 et 54 définissent respectivement les accès IN, OUT1, OUT2 et ISO. Les extrémités internes 51' et 52' des enroulements 51 et 52 sont reliées par un via conducteur 55 (figure 7 et pointillés aux figures 5A et 5B). Les extrémités internes 53' et 54' des enroulements 53 et 54 sont reliées entre elles par un via conducteur 56. L'ordre d'empilement des niveaux conducteurs est indifférent. D'autres niveaux conducteurs et/ou isolants non représentés aux figures peuvent être prévus selon l'application.

Dans l'exemple représenté, une fois la structure terminée (figure 6), les enroulements 51 et 53 tournent, vus de dessus et depuis l'extérieur, dans le sens des aiguilles d'une montre tandis que les enroulements 52 et 54 tournent dans le sens inverse. Le contraire est bien entendu possible pourvu que les enroulements constitutifs d'une même ligne tournent dans des sens inverses (depuis l'extérieur) de sorte que le courant d'une même ligne tourne dans le même sens sur toute la ligne.

Le fait d'empiler et d'interdigiter des différents enroulements permet un premier effet de couplage du premier enroulement sur lui-même grâce au deuxième enroulement réalisé dans le niveau du dessous ou de dessus et un deuxième effet de couplage par le fait que l'enroulement est interdigité avec un enroulement de l'autre ligne. Cet accroissement du coefficient de couplage permet, entre autres, que les longueurs développées des lignes formant les enroulements puissent être inférieures au quart de la longueur d'onde de la fréquence de travail du coupleur. Le fait de prévoir des largeurs de lignes conductrices croissantes entre l'accès de la ligne (largeur W1, figure 5B) et son extrémité intérieure (largeur W2) permet, pour un courant donné, de réduire la surface occupée par les enroulements. Les largeurs des lignes sont de préférence les mêmes à tous les accès et les mêmes à toutes les extrémités internes.

Comme l'illustrent les figures 6 et 7, une piste conductrice 25 est réalisée dans le niveau conducteur 2 superposé aux deux autres 1 et 4, par exemple en étant séparé du niveau 1 par une couche isolante 3. La piste 25 est reliée par ses extrémités respectives et des vias 35 et 36 (figure 6) au plan de masse 12 du niveau 1. Le cas échéant, une autre piste de transfert thermique peut être réalisée sous le niveau 4 (avec interposition d'un isolant) et être reliée au plan 12. Chaque niveau d'enroulement est alors associé à un pont thermique.

Pour respecter le schéma de la figure 4, les éléments capacitifs C1 et C2 optionnels (figure 6) sont réalisés, par exemple sous la forme d'éléments localisés et non répartis. Ces éléments capacitifs améliorent le couplage entre les spires et par conséquent les performances du diviseur/combineur. Un autre effet des éléments capacitifs est de régler la bande de fréquence de fonctionnement du combineur.

Dans le mode de réalisation illustré par les figures 4 à 7, le nombre de tours de chaque niveau conducteur 1 et 2 est différent d'un quart de tour. Cela permet de rendre proches les unes des autres les extrémités externes des enroulements définissant les accès du combineur/diviseur. Il est alors possible de connecter les éléments capacitifs C1 et C2 à des extrémités comme l'illustre la figure 6 sans allonger les lignes couplées. Un avantage est que cela permet de ne pas avoir de longues connexions pour connecter les capacités et réduit donc le risque de dégradation des performances du combineur.

La bande passante du combineur/diviseur dépend du nombre de tours des enroulements (donc de la valeur de l'inductance) ainsi que de la valeur des éléments capacitifs associés. Pour une fréquence de travail donnée (fréquence centrale de la bande passante du combineur/diviseur), plus les enroulements sont courts, plus les valeurs des éléments capacitifs associés sont élevées. Dans des applications haute fréquence (supérieure à 100 mégahertz) que vise plus particulièrement ce mode de réalisation, les éléments capacitifs auront des valeurs comprises entre 0,1 et 10 picofarads.

La figure 8 est un schéma-blocs d'un circuit d'émission radiofréquence utilisant des structures d'enroulements plans susceptibles d'être réalisées selon l'un des modes de mise en oeuvre décrits. Dans l'exemple, un combineur 61 est intercalé entre des sorties OUTO et OUT90 déphasées de 90° l'une par rapport à l'autre de deux amplificateurs de puissance 71 et 72 (PA) d'une tête 70 d'émission radiofréquence. Le cas échéant, des circuits 73 et 74 d'adaptation d'impédance (MATCH), représentés en pointillés, sont intercalés entre les amplificateurs 71 et 72 et les accès OUT1 et OUT2 du combineur 61. Chaque amplificateur 71, 72 reçoit un signal radiofréquence RF0, RF90 provenant d'un circuit 75 de déphasage (PHASE SHIFT) qui reçoit lui-même deux signaux radiofréquence différentiels RFIN+ et RFIN- à transmettre. Les signaux RFIN+ et RFIN- sont en opposition de phase l'un par rapport à l'autre. Le circuit 70 est alimenté par une tension Valim généralement continue. Le combineur 61 additionne les signaux OUTO et OUT90 pour former un signal IN envoyé sur une antenne 76 pour émission. Le cas échéant, un coupleur non représenté est adjoint au combineur pour extraire une information proportionnelle à la puissance transmise POUT sur l'accès IN de façon à ajuster éventuellement les gains des amplificateurs 11 et 12. Pour économiser la puissance consommée par les circuits d'amplification, les signaux sont le plus souvent répartis en deux voies en quadrature de phase. C'est pourquoi les combineurs/diviseurs sont généralement en quadrature de phase pour les accès répartis.

Le même type d'architecture peut être utilisé pour une chaîne de réception. Dans ce cas, l'accès combiné (IN) sert de borne d'entrée tandis que les deux accès répartis (OUT1 et OUT2) servent de bornes de sortie déphasées (en quadrature de phase) vers deux entrées de réception d'une tête de réception radiofréquence.

Des structures d'enroulements plans formant des éléments inductifs peuvent être utilisées pour la réalisation du déphaseur 75, des adaptateurs d'impédance 73 et 74, du combineur 61 et du coupleur.

La figure 9 est un schéma-blocs d'un autre exemple de circuit 79 susceptible d'être réalisé en lignes distribuées par des enroulements plans. Il s'agit d'un transformateur à changement de mode plus généralement connu sous son appellation anglo-saxonne balun pour balanced/unbalanced. Un tel dispositif est utilisé pour transformer une tension de mode commun présente sur un accès UNBAL référencé par rapport à une masse M en deux tensions V1 et V2 différentielles sur des accès BAL1 et BAL2 référencés par rapport à une masse M' (identique ou différente de la masse M). Un balun peut, par exemple, être en série avec un déphaseur pour réaliser un combineur. Dans un balun, quatre éléments inductifs couplés deux à deux sont utilisés. Par conséquent, dans une réalisation par enroulements plans, deux structures du type de celle représentée aux figures 5 à 7 sont placées côte à côte ou empilées.

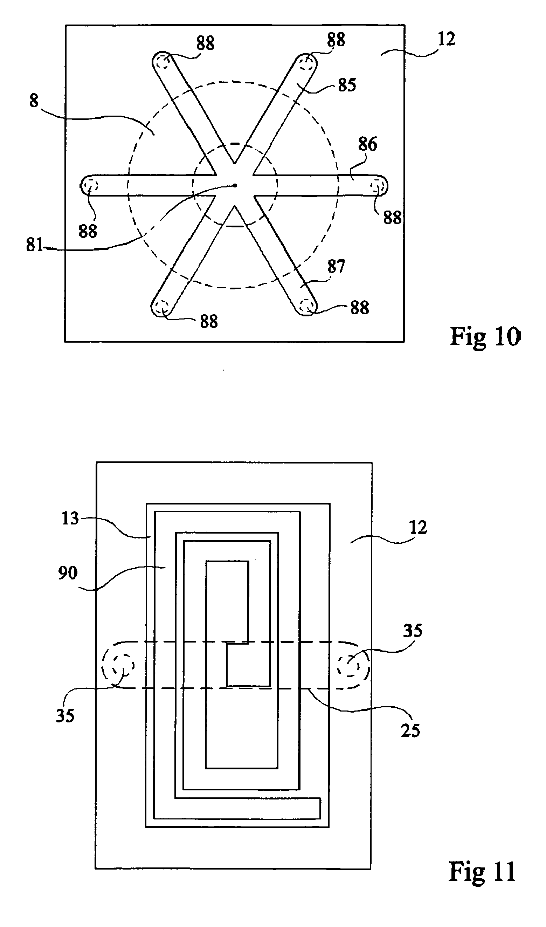

La figure 10 représente un autre mode de réalisation dans lequel trois ponts 85, 86 et 87 de reprise thermique sont prévus sur une structure spiralée plane (représentée par son encombrement pointillé 8) encadrée par un plan de masse 12. Les éléments 85, 86 et 87 sont réalisés dans un niveau conducteur différent de celui ou de ceux servant à former la structure spiralée et se coupent en leurs milieux, au centre 81 de la structure. Leurs extrémités respectives sont reliées par des vias 88 au plan de masse 12.

Augmenter le nombre de ponts thermiques permet d'évacuer plus de chaleur pour un même courant et donc de diminuer l'encombrement de la structure spiralée. Toutefois, cela s'effectue au prix d'une dégradation des performances électriques (facteur de qualité pour un seul élément inductif ou pertes d'insertion accrues pour un combineur), de sorte qu'un compromis sera effectué en fonction de l'application.

La figure 11 est une vue de dessus d'un autre mode de réalisation dans lequel la structure spiralée, réalisée à l'intérieur d'une ouverture 13 du plan de masse 12, est un enroulement plan 90 de forme carrée. En figure 11, la piste 25 de reprise thermique a été représentée en pointillés.

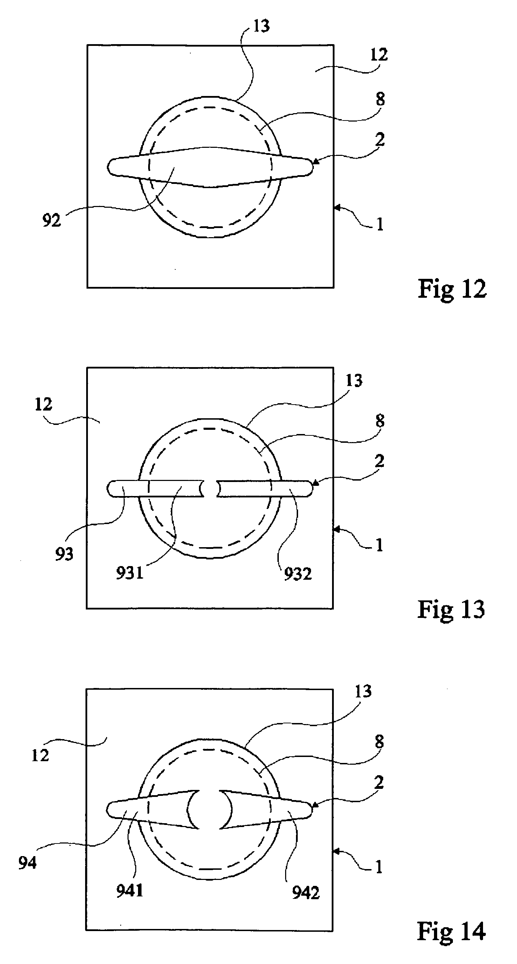

Les figures 12, 13 et 14 sont des vues de dessus schématiques illustrant des variantes de réalisation du pont thermique d'une structure spiralée. Pour simplifier la représentation des figures 12 à 14, l'encombrement de la structure spiralée a été illustrée par un pointillé 8 dans une ouverture circulaire 13 du plan de masse 12 alors qu'en pratique l'ouverture 13 définit le plus souvent au moins un espace (voir les figures 1 et 6) pour une reprise de contact d'au moins une extrémité d'un enroulement. De plus, les éventuelles reprises de contact d'extrémités internes des enroulements dans un des niveaux représentés ou dans un autre n'ont pas été illustrées.

La variante de la figure 12 illustre le cas une piste 92 non rectiligne mais plus large au centre de l'enroulement spiralé qu'aux extrémités de connexion au plan de masse. Ce mode de réalisation permet d'améliorer l'évacuation thermique du centre de la structure par rapport à sa périphérie dont les besoins sont moindres et perturbe ainsi moins les caractéristiques électriques de la structure inductive.

La figure 13 illustre une autre variante dans laquelle une piste 93 est interrompue en son centre de sorte qu'elle se compose de deux tronçons 931 et 932 reliés chacun par une première extrémité au plan de masse 12 à l'extérieur de la structure 8 et dont l'autre extrémité est laissée en l'air à proximité du centre de la structure 8.

La figure 14 illustre une autre variante combinant les variantes des figures 12 et 13, c'est-à-dire une piste de reprise thermique 94 constituée de deux tronçons 941 et 942 plus larges au centre de la structure spiralée qu'aux extrémités reliées au plan de masse 12.

Des modes de réalisation particuliers ont été décrits. Diverses variantes et modifications apparaîtront à l'homme de l'art. En particulier, l'adaptation des dimensions (en particulier de la largeur) de la piste de reprise thermique, ou des pistes de reprise thermique, en fonction de la structure d'enroulement plan inductif concernée est à la portée de l'homme du métier à partir des indications fonctionnelles données ci-dessus.

De plus, l'ordre des niveaux conducteurs empilés dépend également de l'application et, en particulier, des niveaux dans lesquels doivent être ressortis les contacts externes vers le reste du circuit électronique.

En outre, bien que l'on ait fait référence à un plan de masse, il peut s'agir plus généralement d'un plan conducteur quelconque, qu'il soit ou non connecté à un potentiel, son rôle étant de favoriser la dissipation thermique.

Enfin, bien que le pont thermique ait été décrit symétrique par rapport au centre de la structure, l'un de ses tronçons ou côtés pourra être plus long que l'autre, par exemple, en fonction de la forme de l'ouverture 13 dans le plan de masse.

## Revendications

1. Structure spiralée comportant au moins un enroulement plan (11, 51, 52, 53, 54, 8, 90) dans au moins un premier niveau conducteur (1, 4) pour réaliser au moins un élément inductif, ledit enroulement est entouré d'un plan conducteur (12), **caractérisé en ce que** :au moins une piste conductrice (25, 85, 86, 87, 92, 93, 94) est formée dans un deuxième niveau conducteur (2) et a deux extrémités reliées par des vias conducteurs (35, 36, 88) au plan du premier niveau, à des positions diamétralement opposées par rapport au centre (81) de l'enroulement.

2. Structure selon la revendication 1, dans laquelle ladite piste conductrice (25, 85, 86, 87, 92) est continue d'une extrémité à l'autre.

3. Structure selon la revendication 1, dans laquelle ladite piste conductrice (93, 94) est interrompue au centre (81) de l'enroulement (8).

4. Structure selon l'une quelconque des revendications 1 à 3, dans laquelle la largeur (W) de la piste conductrice (25, 85, 86, 87, 92, 93, 94) est, au centre de l'enroulement (8), inférieure ou égale au tiers du diamètre interne (d) de l'enroulement.

5. Structure selon l'une quelconque des revendications 1 à 4, dans lequel ledit plan conducteur (12) est destiné à être raccordé à un potentiel de référence.

6. Structure selon l'une quelconque des revendications 1 à 5, dans laquelle plusieurs pistes conductrices (85, 86, 87) sont réparties dans le deuxième niveau conducteur (2) en ayant leurs extrémités respectives (88) reliées au plan conducteur (12) du premier niveau (1).

7. Structure selon l'une quelconque des revendications 1 à 6, dans laquelle au moins un deuxième enroulement (51, 52) est réalisé dans un troisième niveau conducteur (4) superposé au deux premiers (1, 2).

8. Structure selon l'une quelconque des revendications 1 à 7, dans laquelle deux enroulements plans interdigités (52, 54) sont formés dans le premier niveau (1).

9. Structure selon l'une quelconque des revendications 1 à 8, dans laquelle la largeur (W) de la piste conductrice (92, 94) est plus importante au centre de la structure qu'à ses extrémités destinées à être raccordées au plan conducteur (12) du premier niveau (1).

10. Elément inductif, **caractérisé en ce qu'**il comporte une structure conforme à l'une quelconque des revendications 1 à 9.

11. Combineur/diviseur en lignes distribuées comportant :
une première ligne (L1) formée d'un premier enroulement (51) plan dans un premier niveau conducteur (1) et d'un deuxième enroulement plan (52) dans un troisième niveau conducteur (4) ; et
une deuxième ligne (L2) formée d'un troisième enroulement plan (53) interdigité avec le premier enroulement dans le premier niveau, et d'un quatrième enroulement plan (54) interdigité avec le deuxième enroulement dans le troisième niveau,
**caractérisé en ce qu'**une piste conductrice (25) conforme à la structure selon l'une quelconque des revendications 1 à 10 est formée dans un deuxième niveau conducteur (2) superposé aux deux autres.

12. Combineur/diviseur selon la revendication 11, dans lequel les enroulements (51, 52, 53, 54) ont une largeur croissante de l'intérieur vers l'extérieur.

## Claims

1. A spiral structure comprising at least one planar winding (11, 51, 52, 53, 54, 8, 90) in at least one first conductive level (1, 4) to form at least one inductive element, wherein: said winding is surrounded with a conductive plane (12);
**characterized in that** at least one conductive track (25, 85, 86, 87, 92, 93, 94) is formed in a second conductive level (2) and has two ends connected by conductive vias (35, 36, 88) to the plane of the first level, at diametrically opposite positions with respect to the center (81) of the winding.

2. The structure of claim 1, wherein said conductive track (25, 85, 86, 87, 92) is continuous from one end to the other.

3. The structure of claim 1, wherein said conductive track (93, 94) is interrupted at the center (81) of the winding (8).

4. The structure of any of claims 1 to 3, wherein the width (W) of the conductive track (25, 85, 86, 87, 92, 93, 94) is, at the center of the winding (8), smaller than or equal to one third of the internal diameter (d) of the winding.

5. The structure of any of claims 1 to 4, wherein said conductive plane (12) is intended to be connected to a reference voltage.

6. The structure of any of claims 1 to 5, wherein several conductive tracks (85, 86, 87) are distributed in the second conductive level (2) by having their respective ends (88) connected to the conductive plane (12) of the first level (1).

7. The structure of any of claims 1 to 6, wherein at least one second winding (51, 52) is formed in a third conductive level (4) superposed to the first two (1, 2).

8. The structure of any of claims 1 to 7, wherein two interdigited planar windings (52, 54) are formed in the first level (1).

9. The structure of any of claims 1 to 8, wherein the width (W) of the conductive track (92, 94) is greater at the center of the structure than at its ends intended to be connected to the conductive plane (12) of the first level (1).

10. An inductive element **characterized in that** it comprises the structure of any of claims 1 to 9.

11. A combiner/divider in distributed lines comprising:
a first line (L1) formed of a first planar winding (51) in a first conductive level (1) and of a second planar winding (52) in a third conductive level (4); and
a second line (L2) formed of a third planar winding (53) interdigited with the first winding in the first level, and of a fourth planar winding (54) interdigited with the second winding in the third level,
**characterized in that** a conductive track (25) in accordance with the structure of any of claims 1 to 10 is formed in a second conductive level (2) superposed to the other two.

12. The combiner/divider of claim 11, wherein the windings (51, 52, 53, 54) have a width increasing from the inside to the outside.

## Patentansprüche

1. Spiralstruktur, die Folgendes aufweist: wenigstens eine planare Wicklung (11, 51, 52, 53, 54, 8, 90) in wenigstens einer ersten leitenden Stufe (1, 4) zum Bilden wenigstens eines induktiven Elements, wobei die Wicklung von einer leitenden Ebene (12) umgeben ist, **dadurch gekennzeichnet, dass** wenigstens eine leitende Spur (25, 85, 86, 87, 92, 93, 94) in einer zweiten leitenden Stufe (2) ausgebildet ist, die wenigstens zwei Enden besitzt, die über leitende Durchkontaktierungen (35, 36, 88) zu der Ebene der ersten Stufe verbunden sind, und zwar an diamteral entgegengesetzten Enden bezüglich der Mitte (81) der Wicklung.

2. Struktur nach Anspruch 1, wobei die leitende Spur (25, 85, 86, 87, 92) von einem Ende zum anderen kontinuierlich ist.

3. Struktur nach Anspruch 1, wobei die leitende Spur (93, 94) in der Mitte (81) der Wicklung (8) unterbrochen ist.

4. Struktur nach einem der Ansprüche 1 bis 3, wobei die Breite (W) der leitenden Spur (25, 85, 86, 87, 92, 93, 94) an der Mitte der Wicklung (8) kleiner oder gleich einem Drittel des Innendurchmessers (d) der Wicklung ist.

5. Struktur nach einem der Ansprüche 1 bis 4, wobei die leitende Ebene (12) mit einer Referenzspannung verbunden werden soll.

6. Struktur nach einem der Ansprüche 1 bis 5, wobei mehrere leitende Spuren (85, 86, 87) in der zweiten leitenden Stufe (2) verteilt sind, in dem ihre jeweiligen Enden (88) mit der leitenden Ebene (12) der ersten Stufe (1) verbunden sind.

7. Struktur nach einem der Ansprüche 1 bis 6, wobei wenigstens eine zweite Wicklung (51, 52) in einer dritten leitenden Stufe (4), die den ersten Zwei (1, 2) überlagert ist, ausgebildet ist.

8. Struktur nach einem der Ansprüche 1 bis 7, wobei zwei ineinandergreifende planare Wicklungen (52, 54) in der ersten Stufe (1) ausgebildet sind.

9. Struktur nach einem der Ansprüche 1 bis 8, wobei die Breite (W) der leitenden Spur (92, 94) an der Mitte der Struktur breiter ist, als an ihren Enden, die mit der leitenden Ebene (12) der ersten Stufe (1) verbunden werden sollen.

10. Ein induktives Element, **dadurch gekennzeichnet, dass** es die Struktur nach einem der Ansprüche 1 bis 9, aufweist.

11. Ein Kombinierer/Teiler in verteilten Leitungen, der Folgendes aufweist: ein erste Leitung (L1), gebildet aus einer ersten planaren Wicklung (51), die in einer ersten leitenden Stufe (1) ausgebildet ist und einer zweiten planaren Wicklung (52), die in einer dritten leitenden Stufe (4) ausgebildet ist; und
eine zweite Leitung (L2), die ausgebildet ist, aus einer dritten planaren Wicklung (53), die ineinandergreifend mit der ersten Wicklung in der ersten Stufe vorgesehen ist, und einer vierten planaren Wicklung (54), die ineinandergreifend mit der zweiten Wicklung in der dritten Stufe vorgesehen ist, **dadurch gekennzeichnet, dass** eine leitende Spur (25) gemäß der Struktur nach einem der Ansprüche 1 bis 10 in einer zweiten leitenden Stufe (2), welche die anderen zwei Stufen überlagert, ausgebildet ist.

12. Kombiniere/Teiler nach Anspruch 11, wobei die Wicklung (51, 52, 53, 54) eine Breite besitzen, die sich von der Innenseite zur Außenseite hin erhöht.
